(19) Europäisches Patentamt
European Patent Office
Office européen des brevets

(11) Veröffentlichungsnummer: **0 156 997**
**B1**

(12) **EUROPÄISCHE PATENTSCHRIFT**

(45) Veröffentlichungstag der Patentschrift: **20.07.88**

(21) Anmeldenummer: **84115970.0**

(22) Anmeldetag: **20.12.84**

(51) Int. Cl.⁴: **H 01 L 31/02**, C 07 C 121/64, C 09 B 3/18

(54) **Verfahren zum flächenmässigen Konzentrieren von Licht.**

(30) Priorität: **13.01.84 DE 3400991**

(43) Veröffentlichungstag der Anmeldung: **09.10.85 Patentblatt 85/41**

(45) Bekanntmachung des Hinweises auf die Patenterteilung: **20.07.88 Patentblatt 88/29**

(84) Benannte Vertragsstaaten: **CH DE FR GB IT LI**

(56) Entgegenhaltungen:
**EP-A-0 033 079**
**EP-A-0 081 766**
**DE-A-2 512 516**
**DE-A-2 620 115**
**DE-A-2 851 513**
**FR-A-2 334 163**
**GB-A-254 310**

(73) Patentinhaber: **BASF Aktiengesellschaft, Carl-Bosch- Strasse 38, D-6700 Ludwigshafen (DE)**

(72) Erfinder: **Iden, Rüdiger, Dr., Ruhhecke 25a, D-6720 Speyer (DE)**
Erfinder: **Seybold, Günther, Friedrich- Ebert-Strasse 14, D-6708 Neuhofen (DE)**

**EP 0 156 997 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

**Beschreibung**

Die Erfindung betrifft ein Verfahren zur Konzentrierung von Licht mittels fluoreszierender Verbindungen in Kunststoffplatten oder -folien mittels Perylenverbindungen.

Aus DE-A-30 01 857, DE-A-26 20 115 und DE-A-25 54 226 sind Vorrichtungen bekannt, in denen sichtbares Licht in einer Kunststoffplatte durch eingelagerte Fluoreszenzzentren auf eine kleine Fläche konzentriert werden kann.

In der EP-A-0 033 079 wird die flächenmäßige Konzentration von Licht mittels fluoreszierender Verbindungen beschrieben, die der Formel

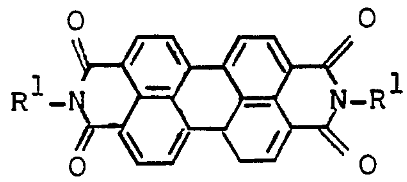

entsprechen, worin beide $R_1$ gleiche oder verschiedene keine wasserlöslich machende Gruppen enthaltende orthosubstituierte aromatische oder heterocyclische Reste sind. Als aromatische und heterocyclische Reste kommen für $R_1$ orthosubstituiertes Phenyl, Naphthyl-1, 5,6,7,8-Tetrahydronaphthyl-1, Chinolinyl-1, Pyrazolyl-5 und Benzisothiazolyl-3, die gegebenenfalls noch durch 1 oder 2 Reste substituiert sein können, in Betracht.

Die gemäß der EP-A-0 033 079 als Fluoreszenzzentren verwendeten Verbindungen sind im Gegensatz zu den nicht in ortho-Stellung substituierten N,N-Bisarylimiden der Perylen-3,4,9,10-tetra-carbonsäure in organischen Lösungsmitteln und in Kunststoffen wesentlich besser löslich (S. 10, Z.4/ 13). Die bei dem Verfahren EP-A angewendeten Farbstoffe geben sehr lichtechte Färbungen.

Die in diesen Vorrichtungen als Fluoreszenzzentren benötigten Verbindungen müssen insbesondere im Falle der Umwandlung von Lichtenergie in elektrische oder thermische Energie eine hohe Lichtechtheit aufweisen, damit die Vorrichtungen eine für die Anwendung ausreichende Lebensdauer aufweisen. D.h., die als Fluoreszenzzentren verwendeten Verbindungen müssen in den verwendeten Kunststoffen eine hohe Photostabilität aufweisen.

Es ist bekannt, daß Derivate der Perylen-3,9-dicarbonsäure als Fluoreszenzzentren mit ausreichender Quantenausbeute zur Konzentrierung von Licht verwendet werden können, jedoch haben diese Verbindungen den Nachteil, daß diese eine ungenügende Photostabilität, z. B. in Polymethylmethacrylat aufweisen.

Aufgabe der vorliegenden Erfindung war es, für die bekannten Vorrichtungen zur Lichtkonzentrierung als Fluoreszenzzentren geeignete Verbindungen bereitzustellen, die bei gleichzeitig hoher Lichtechtheit in dem verwendeten Medium eine hohe Fluoreszenzquantenausbeute aufweisen und die auf das Medium keine nachteilige Wirkung ausüben.

Es wurde gefunden, daß man bei der flächenmäßigen Konzentrierung von Licht mit Hilfe von Fluoreszenzzentren in Kunststoffplatten oder -folien hervorragende Ergebnisse erzielt, wenn man als Fluoreszenzzentren Perylenverbindungen der Formel

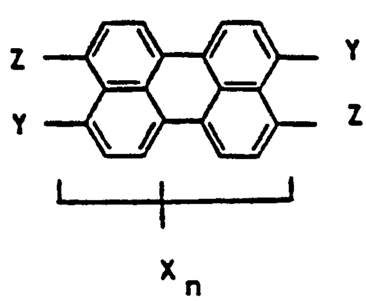

(I)

verwendet, in der

X für Halogen,

n für 0, 1 oder 2 und entweder

ein Y für Cyan und das andere Y für Cyan oder Halogen und

Z für $-COOR^1$, worin

$R^1$ Wasserstoff, lineares oder verzweigtes $C_1$- bis $C_{18}$-Alkyl, durch $C_5$-bis $C_{18}$-Cycloalkyl substituiertes $C_1$- oder $C_2$-Alkyl oder $C_7$- bis $C_{18}$-Cycloalkyl, wobei die Cycloalkylreste 1 bis 4 Ringe enthalten können, bedeutet, oder

Y für Cyan und

Z für Cyan, Halogen oder Wasserstoff stehen, wobei beide Z gleich oder verschieden sein können.

Mit den erfindungsgemäß zu verwendenden Perylenverbindungen (I) erhält man in den Kunststoffen, die zur

Herstellung der für die Lichtkonzentration benötigten Platten oder Folien verwendet werden, sehr lichtechte Färbungen, die das eingestrahlte Licht in hoher Ausbeute in Fluoreszenzlicht umwandeln. Die Wellenlänge des Fluoreszenzlichtes liegt zwischen 450 und 550 nm.

Für das erfindungsgemäße Verfahren sind Perylenverbindungen der Formel (I) bevorzugt, in der X für Chlor oder Brom, n für 0, 1 oder 2 und entweder beide Y für Cyan und Z für Cyan, Halogen, vorzugsweise Brom oder Chlor oder Wasserstoff und wobei beide Z gleich oder verschieden sein können, oder ein Y für Cyan und das andere Y für Cyan oder Halogen, vorzugsweise Brom oder Chlor und beide Z für -COOR[1] stehen, worin R[1] die oben angegebene Bedeutung hat.

Die bevorzugt zu verwendenden Perylenverbindungen entsprechen den Formeln (II), (III) und (IV):

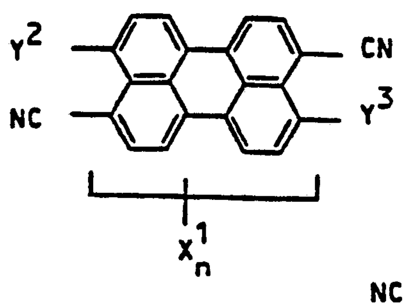
(II),

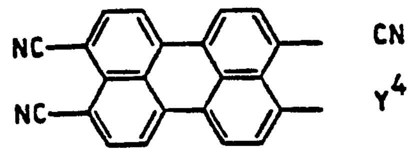
(III),

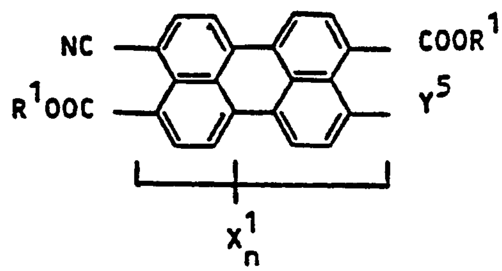
(IV)

In den Formeln (II) (III) und (IV) stehen $X^1$ für Chlor oder Brom, n für 1 oder 2, $Y^2$ und $Y^3$ unabhängig voneinander für Wasserstoff, Cyan, Halogen, das vorzugsweise Chlor oder Brom ist, $Y^4$ für Brom oder Cyan, $Y^5$ für Cyan oder Halogen, das vorzugsweise Chlor oder Brom ist, und $R^1$ für Wasserstoff, lineares oder verzweigtes $C_1$- bis $C_{18}$-Alkyl, durch $C_5$- bis $C_{18}$-Cycloalkyl substituiertes $C_1$- oder $C_2$-Alkyl oder für $C_7$- bis $C_{18}$-Cycloalkyl und wobei die Cycloalkylreste 1 bis 4 Ringe enthalten können.

$R^1$ steht vorzugsweise für $C_4$- bis $C_{18}$-Alkyl, insbesondere für n-Butyl, i-Butyl, Neopentyl, 2-Ethylhexyl, n-Octyl, Tridecyl oder Octadecyl.

Besonders bevorzugt sind die Perylenverbindungen der Formeln (III) und (IV).

Die Verfahren zur Herstellung der Verbindungen (1) sind bekannt. Die Herstellung der neuen Perylenverbindungen (IV) erfolgt nach an sich bekannten Verfahren.

Zur Anwendung werden die Verbindungen (I) in für die Anwendung geeigneten Kunststoffen (Medien) eingearbeitet. Hierzu wird der Kunststoff als Granulat mit der benötigten Menge an (I) gepudert und die Granulate dann zu Flächengebilden extrudiert. Mit (I) gefärbte Flächengebilde können auch durch Eintauchen der Gebilde in eine Lösung von (I) erhalten werden, wobei (I) in den Kunststoff diffundiert. Eine weitere Möglichkeit besteht darin, die (I) enthaltenden Monomere oder Monomerengemische zum Kunststoff zu polymerisieren. Man kann die Flächengebilde auch durch Gießen aus einer Lösung, die den Kunststoff und die Verbindung (I) gelöst enthält, herstellen.

Für die Verwendung zur Konzentration von Licht, z. B. für Solarzellen kommen als Kunststoffe (Medium) z. B. Polymethylmethacrylat, Polymethylacrylat, Polystyrol, Polydiethylenglykol-diallylbiscarbonat, ferner auch für diesen Zweck geeignete Polyamide und Polycarbonate in Betracht.

Die Erfindung soll durch die folgenden Beispiele weiter erläutert werden. Die im folgenden angegebenen Teile und Prozentangaben beziehen sich auf das Gewicht.

PMMA = Polymethylmethacrylat

Sulfolan = Tetrahydrothiophen-1,1-dioxid.

**Beispiel 1**

a) In 100 Teilen Sulfolan wurden 12 Teile 3,4,9,10-Tetrabromperylen (erhalten durch Bromierung von Perylen in Nitrobenzol) und 18 Teile Kupfercyanid 14 Stunden auf 160 bis 170°C erhitzt. Das Reaktionsgemisch wurde auf 500 Teile Eis gefällt und abgesaugt. Der Rückstand wurde mit 1000 Teilen 10 %-iger Ammoniaklösung digeriert, abgesaugt, mit Wasser gewaschen und getrocknet.

Durch Extraktion mit Chloroform wurden 5 Teile (57 % der Theorie) 3,4,9-Tricyan-10-bromperylen erhalten,

das chromatographisch weiter gereinigt werden kann.

$C_{23}H_8N_3Br$ (M. 405,9)

Br. ber.: 19,3 gef.: 18,8 %

Schmp. 235-237° C

b) 0,01 Teile der nach a) erhaltenen Perylenverbindung wurden in 1000 Teile PMMA eingearbeitet, die erhaltene Färbung weist ein Absorptionsmaximum bei 465 nm und ein Emissionsmaximum bei 516 nm auf.

**Beispiel 2**

a) 10 Teile der nach Beispiel 1 erhaltenen Perylenverbindung wurden nochmals nach den Angaben des Beispiels 1 mit Kupfercyanid umgesetzt.

Ausbeute: 8 Teile 3,4,9,10-Tetracyanoperylen.

$C_{24}H_8N_4$ (M 352)

N: ber.: 15,9 gef.: 15,4 %

Schmp. 285-287° C.

Fluoreszenzquantenausbeute (in Chloroform): 83 %.

b) Dieser Farbstoff wird in PMMA eingearbeitet (Konzentration: 0,01 %), die erhaltene Färbung zeigt eine brillante gelbgrüne Fluoreszenz, die Quantenausbeute beträgt über 80 %.

Absorptionsmaximum: 474 nm

Emissionsmaximum: 505 nm

c) An der durch Extrusion erhaltenen Platte wurde die Abnahme der Extinktion bei $\lambda_{max}$ ($\Delta Ext\lambda_{max}$) durch Belichtung im XENOTEST® -Gerät bei einer Beleuchtungsstärke von 200 000 Lux und Tageslichtfilter bestimmt nach 168 h: $\Delta$ Ext.$\lambda_{max}$ = 3 %.

**Beispiel 3**

3,9-Dicyanoperylen wird in PMMA eingearbeitet (Konzentration: 0,05 %) und das Gemisch zu Platten gegossen. Das Absorptionsmaximum des Systems liegt bei 462 nm, das Emissionsmaximum bei 498 nm.

**Beispiel 4**

a) In 100 Teile Sulfolan wurden 12 Teile 4,10-Dibrom-perylen-3,9-di-carbonsäureisobutylester und 9 Teile Kupfercyanid 25 Stunden bei 130 bis 140° C gerührt.

Das Umsetzungsprodukt wurde durch Austragen auf 400 Teile Wasser gefällt, abgesaugt, das Filtergut in verdünntem Ammoniak digeriert, abgesaugt, mit Wasser neutral gewaschen und getrocknet. Nach der Extraktion mit Toluol wurden 9 Teile Rohfarbstoff mit einem Bromgehalt von 1,2 % isoliert.

Der Farbstoff wurde durch Mitteldruck-Säulenchromatographie an Kieselgel mit Trichlorethan/Ethanol als Eluens gereinigt.

Ausbeute: 6 Teile 4,10-Dicyanperylen-3,9-dicarbonsäureisobutylester.

Schmp. 228-230° C.

Fluoreszenzquantenausbeute in Chloroform: 91 %.

b) Dieser Farbstoff wurde in PMMA (Konzentration: 0,05 %) eingearbeitet. Das Absorptionsmaximum liegt bei 474 nm und das Emissionsmaximum bei 508 nm.

Nach 168stündiger Belichtung (vgl. Beisp. 2c)) $\Delta Ext_{\lambda max}$ = 4 %.

**Beispiel 5 bis 10**

Es wurde entsprechend den Angaben in Beispiel 4 verfahren, jedoch wurde anstelle des 4,10-Dibromperylen-3,9-dicarbonsäureisobutylesters die äquivalente Menge der in der Tabelle angegebenen Ester verwendet.

Die erhaltenen Rohester wurden durch Säulenchromatographie gereinigt.

Das Absorptions- und Emissionsmaximum der Ester wurde an 0,05 %-igen Färbungen in PMMA bestimmt.

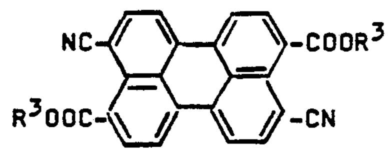

| Beispiel | $R^3$ | Absorptions- maximum (PMMA) [nm] | Emissions- maximum (PMMA) [nm] |
|---|---|---|---|
| 5 | $-CH_2-CH_2-CH_2-CH_3$ | 474 | 509 |
| 6 | $-CH_2-C(CH_3)_2-CH_3$ | 473 | 508 |
| 7 | $-CH_2-CH-C_4H_9(n)$ | 474 | 509 |
| | \| $C_2H_5$ | | |
| 8 | $-C_8H_{17}(n)$ | 474 | 508 |
| 9 | $-C_{13}H_{27}(n)$ | 473 | 508 |
| 10 | $-C_{18}H_{37}(n)$ | 474 | 507 |

**Patentansprüche**

1. Verfahren zur flächenmäßigen Konzentrierung von Licht mit Hilfe von Fluoreszenzzentren in Kunststoffplatten oder -folien, dadurch gekennzeichnet, daß man als Fluoreszenzzentren Perylenverbindungen der Formel

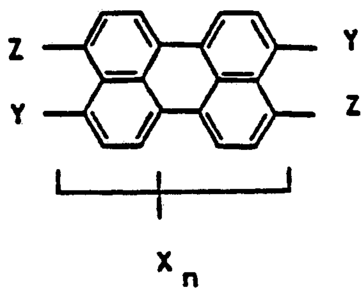

(I)

verwendet, in der
X für Halogen,
n für 0, 1 oder 2 und entweder
ein Y für Cyan und das andere Y für Cyan oder Halogen und
Z für $-COOR^1$, worin
$R^1$ Wasserstoff, lineares oder verzweigtes $C_1$- bis $C_{18}$-Alkyl, durch $C_5$- bis $C_{18}$-Cycloalkyl substituiertes $C_1$- oder $C_2$-Alkyl oder $C_7$- bis $C_{18}$-Cycloalkyl, wobei die Cycloalkylreste 1 bis 4 Ringe enthalten können, bedeutet, oder
Y für Cyan und
Z für Cyan, Halogen oder Wasserstoff stehen, wobei beide Z gleich oder verschieden sein können.

2. Verfahren gemäß Anspruch 1, dadurch gekennzeichnet, daß man als Fluoreszenzzentren Verbindungen der Formel (I) verwendet, in der X für Chlor oder Brom, n für 0, 1 oder 2, und entweder beide Y für Cyan und Z für Cyan, Wasserstoff oder Halogen, wobei beide Z gleich oder verschieden sein können, oder ein Y für Cyan und das andere Y für Cyan oder Halogen und beide Z für $-COOR^1$ stehen, worin $R^1$ die in Anspruch 1 angegebene Bedeutung hat.

3. Verfahren gemäß Anspruch 2, dadurch gekennzeichnet, daß beide Y für Cyan und Z für Cyan, Wasserstoff, Brom oder Chlor stehen, wobei beide Z gleich oder verschieden sein können.

4. Verfahren gemäß Anspruch 2, dadurch gekennzeichnet, daß ein Y für Cyan, das andere Y für Cyan, Chlor oder Brom und beide Z für $-COOR^1$ stehen.

5. Verfahren gemäß Anspruch 1, dadurch gekennzeichnet, daß man als Fluoreszenzzentren Verbindungen der

Formeln

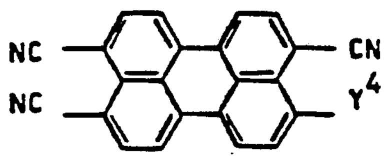

oder

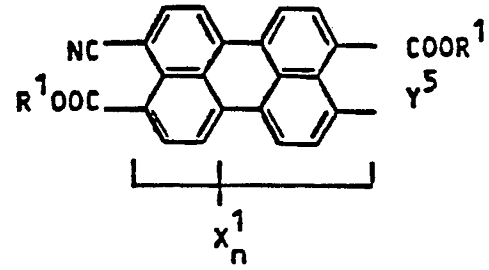

verwendet, in denen $X^1$ für Chlor oder Brom, n für 0, 1 oder 2, $Y^4$ für Brom oder Cyan und $Y^5$ für Cyan oder Halogen stehen und $R^1$ die in Anspruch 1 angegebene Bedeutung hat.

6. Verfahren gemäß Anspruch 3, <u>dadurch gekennzeichnet,</u> daß $Y^5$ für Cyan, Chlor oder Brom steht.

7. Verfahren gemäß Anspruch 5, <u>dadurch gekennzeichnet,</u> daß man als Fluoreszenzzentren Verbindungen der Formel

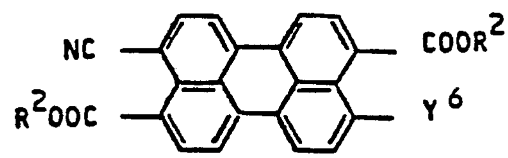

verwendet, in der $Y^6$ für Cyan und $R^2$ für lineares oder verzweigtes $C_4$- bis $C_{18}$-Alkyl stehen.

8. Verfahren gemäß Anspruch 7, <u>dadurch gekennzeichnet,</u> daß in der Formel $Y^6$ für Cyan und $R^2$ für n-Butyl, i-Butyl, 2-Ethylhexyl, Neopentyl, n-Octyl, n-Tridecyl oder n-Octadecyl steht.

**Claims**

1. A method for concentrating light over a particular area with the aid of fluorescence centers in a plastic sheet or film, wherein the fluorescence centers used comprise a perylene compound of the formula

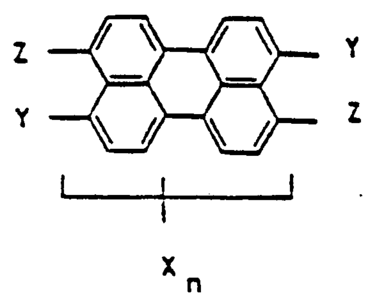

(I)

where

X is halogen,

n is 0, 1 or 2, and either

one radical Y is cyano and the other is cyano or halogen and

Z is -$COOR^1$, where

$R^1$ is hydrogen, straight-chain or branched $C_1$-$C_{18}$-alkyl, $C_5$-$C_{18}$-cycloalkyl-substituted $C_1$- or $C_2$-alkyl or $C_7$-$C_{18}$-cycloalkyl, and the cycloalkyl radical can contain from 1 to 4 rings, or

Y is cyano and

Z is cyano, halogen or hydrogen, and the two radicals Z can be identical or different.

2. A method as claimed in claim 1, wherein the fluorescence centers used comprise a compound of the formula (I) where X is chlorine or bromine, n is 0, 1 or 2, and either both radicals Y are cyano and Z is cyano, hydrogen or halogen, and the two radicals Z can be identical or different, or one radical Y is cyano and the other is cyano or halogen and both radicals Z are -$COOR^1$, where $R^1$ has the meanings given in claim 1.

3. A method as claimed in claim 2, wherein the two radicals Y are cyano and Z is cyano, hydrogen, bromine or chlorine, and the two radicals Z can be identical or different.

4. A method as claimed in claim 2, wherein one radical Y is cyano and the other is cyano, chlorine or bromine, and the two radicals Z are -$COOR^1$.

5. A method as claimed in claim 1, wherein the fluorescence centers used comprise a compound of the formulae

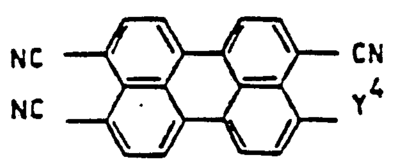

or

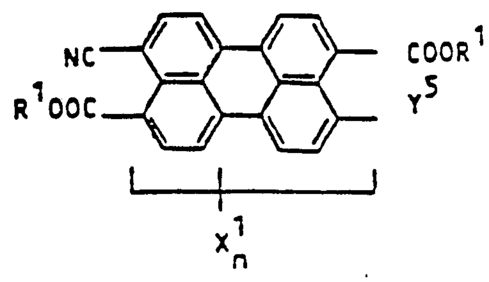

.

where $X^1$ is chlorine or bromine, n is 0, 1 or 2, $Y^4$ is bromine or cyano, $Y^5$ is cyano or halogen and $R^1$ has the meanings given in claim 1.

6. A method as claimed in claim 3, wherein $Y^5$ is cyano, chlorine or bromine.

7. A method as claimed in claim 5, wherein the fluorescence centers used comprise a compound of the formula

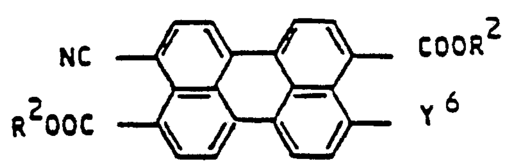

where $Y^6$ is cyano and $R^2$ is straight-chain or branched $C_4$-$C_{18}$-alkyl.

8. A method as claimed in claim 7, wherein, in the formula, $Y^6$ is cyano and $R^2$ is n-butyl, isobutyl, 2-ethylhexyl, neopentyl, n-octyl, n-tridecyl or n-octadecyl.

**Revendications**

1. Procédé dé concentration de la lumière sur une surface plane au moyen de centres de fluorescence dans des plaques ou feuilles de matière plastique, caractérisé en ce qu'on utilise, en tant que centres de fluorescence, des composés du pérylène de formule

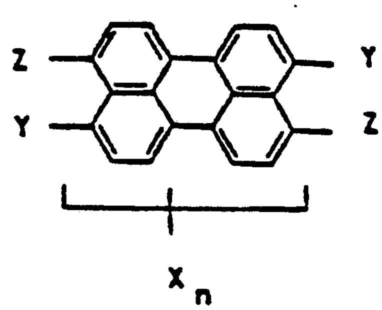

(I)

dans laquelle

X est mis pour un atome d'halogène,

n est mis pour 0, 1 ou 2 et

ou bien l'un des symboles Y est mis pour un radical cyano et l'autre pour un radical cyano ou un atome d'halogène et Z pour un groupement -$COOR^1$, $R^1$ représentant un atome d'hydrogène, un radical alkyle en $C_1$, à $C_{18}$ à chaîne linéaire ou ramifiée, un radical alkyle en $C_1$ ou $C_2$ substitué par un groupe cycloalkyle en $C_5$ à $C_{18}$ ou un radical cycloalkyle en $C_7$ à $C_{18}$, les radicaux cycloalkyle pouvant contenir 1 à 4 noyaux,

ou bien Y est mis pour un radical cyano et Z pour un radical cyano, un atome d'halogène ou d'hydrogène, les deux radicaux Z pouvant être identiques ou différents.

2. Procédé selon la revendication 1, caractérisé en ce qu'on utilise, en tant que centres de fluorescence, des composés de formule (I) dans laquelle X est mis pour un atome de chlore ou de brome, n est mis pour 0, 1 ou 2 et ou bien les deux symboles Y sont mis pour des radicaux cyano et Z est mis pour un radical cyano, un atome d'hydrogène ou d'halogène, les deux radicaux Z pouvant être identiques ou différents, ou bien l'un des symboles Y est mis pour un radical cyano et l'autre pour un radical cyano ou un atome d'halogène et les deux symboles Z sont mis pour des groupements -$COOR_1$, $R_1$ ayant la signification donnée dans la revendication 1.

3. Procédé selon la revendication 2, caractérisé en ce que les deux symboles Y sont mis pour des radicaux cyano et Z pour un radical cyano, un atome d'hydrogène, de brome ou de chlore, les deux symboles Z pouvant être identiques ou différents.

4. Procédé selon la revendication 2, caractérisé en ce que l'un des symboles Y est mis pour un radical cyano, l'autre symbole Y pour un radical cyano, un atome de chlore ou de brome et les deux symboles Z sont mis pour des groupements -$COOR^1$.

5. Procédé selon la revendication 1, caractérisé en ce qu'on utllisé, en tant que centres de fluorescence, des composés de formules

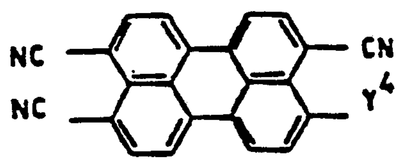

ou

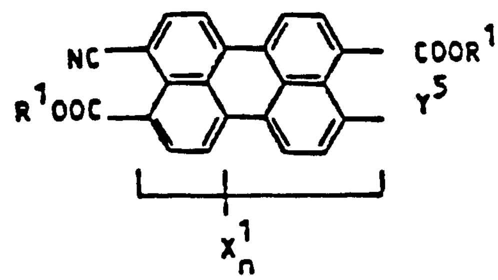

dans lesquelles $X^1$ est mis pour un atome de chlore ou de brome, n est mis pour 0, 1 ou 2, $Y^4$ est mis pour un atome de brome ou un radical cyano et $Y^5$ est mis pour un radical cyano ou un atome d'halogène, et $R^1$ a la signification donnée dans la revendication 1.

6. Procédé selon la revendication 3, caractérisé en ce que $Y^5$ est mis pour un radical cyano ou pour un atome de chlore ou de brome.

7. Procédé selon la revendication 5, caractérisé en ce qu'on utilise, en tant que centres de fluorescence, des composés de formule

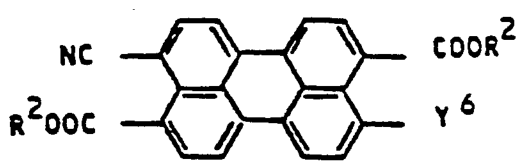

dans laquelle $Y^6$ est mis pour un radical cyano et $R^2$ pour un radical alkyle en $C_4$ à $C_{18}$ à chaîne linéaire ou ramifiée.

7. Procédé selon la revendication 7, caractérisé en ce que dans la formule, $Y^6$ est mis pour un radical cyano et $R^2$ pour un radical n-butyle, i-butyle, 2-éthylhexyle, néopentyle, n-octyle, n-tridécyle ou n-octadécyle.